# EUROPEAN PATENT SPECIFICATION

(11) **EP 0 813 236 B1**
(45) Date of publication and mention of the grant of the patent: **17.01.2007**
(21) Application number: 97201750.3
(22) Date of filing: 10.06.1997
(51) Int. Cl.: H01L 21/56

(54) **Method for encapsulating an integrated semi-conductor circuit**
Verfahren zum Einkapseln einer integrierten Halbleiterschaltung
Procédé d'encapsulation d'un circuit intégré à semi-conducteur

(30) Priority: 11.06.1996 NL 1003315
(43) Date of publication of application: 17.12.1997
(73) Proprietor: Elmos Advanced Packaging B.V., 6545 CL Nijmegen (NL)
(72) Inventor: Kaldenberg, Peter Jacobus, 6533 GN Nijmegen (NL)
(74) Representative: van Westenbrugge, Andries

(56) References cited:
- DE-A- 4 424 541
- US-A- 4 894 707
- PATENT ABSTRACTS OF JAPAN vol. 005, no. 007 (E-041), 17 January 1981 & JP 55 138845 A (CITIZEN WATCH CO LTD), 30 October 1980,
- PATENT ABSTRACTS OF JAPAN vol. 014, no. 244 (E-0932), 24 May 1990 & JP 02 067750 A (FUJI ELECTRIC CO LTD), 7 March 1990,
- PATENT ABSTRACTS OF JAPAN vol. 009, no. 270 (E-353), 26 October 1985 & JP 60 113950 A (HITACHI SEISAKUSHO KK), 20 June 1985,

## Description

Method of encapsulating a semiconductor chip with a plastic housing.

The invention relates to a method of encapsulating a semiconductor chip with a plastic housing comprising the steps of:
a) attaching the semiconductor chip on a mounting surface of a leadframe such that an upper surface of the semiconductor chip is exposed;
b) attaching bonding wires between contact surfaces of the semiconductor chip and selected parts of the leadframe;
c) placing the structure obtained in step b) in a mould which comprises an inwards extending section with an end surface extending parallel to the upper surface and being at a short distance of the upper surface and a layer of deformable heat resistant material is applied to the end surface such that a part of the upper surface is covered by the layer of deformable heat resistant material, the deformable heat resistant material is of a material which does not adhere or hardly adheres to the plastic housing to be formed; and
d) forming the plastic housing by injecting a resin into the mould with the structure obtained in step b) therein after step c) such that a part of the leadframe, the bonding wires and the semiconductor chip are encapsulated, whereby the part of the upper surface is maintained free from the resin by the layer of deformable heat resistant material.

Such a method is known from DE-A-442541. The layer of material between said upper surface and said end surface consists of a photoresist which is left on the chip at the end of the wafer processing operation whereby the chip was formed together with a lot of other chips. After separating the various chips from the wafer chip can be encapsulated using the above described method.

A first disadvantage is that the above described method can be applied only if in the preceding wafer manufacturing process the layer of photoresist used during the final process steps is selectively only partly removed such that the selected part of the upper chip surface is still covered at the end of the wafer manufacturing process that implies that an inspection of that selected surface part is impossible.

A further disadvantage is that after the encapsulation process the resist layer has to be removed using a chemical process, which implies at least one additional process step.

The object of the invention is to eliminate these disadvantages.

This object is fulfilled with a method as described above, which in agreement with the invention is characterised in that the deformable heat resistant material consists of a gel.

The invention will be explained in more detail with reference to the attached drawings.

Figure 1 illustrates a cross-section through a mould with therein the semi-conductor circuit, the lead frame and the connecting wires between the circuit and the frame.

Figure 2 illustrates a cross-section through the mould after the opening at the upper side is closed by an inwards extending component, fluid material is applied in the form of a layer or ring between said component and the semi-conductor circuit and the plastic, which forms the encapsulation, is injected.

Figure 3 illustrates a cross-section through the housing after removing said housing from the mould.

Figure 4 illustrates a cross-section through the housing after positioning a closing window.

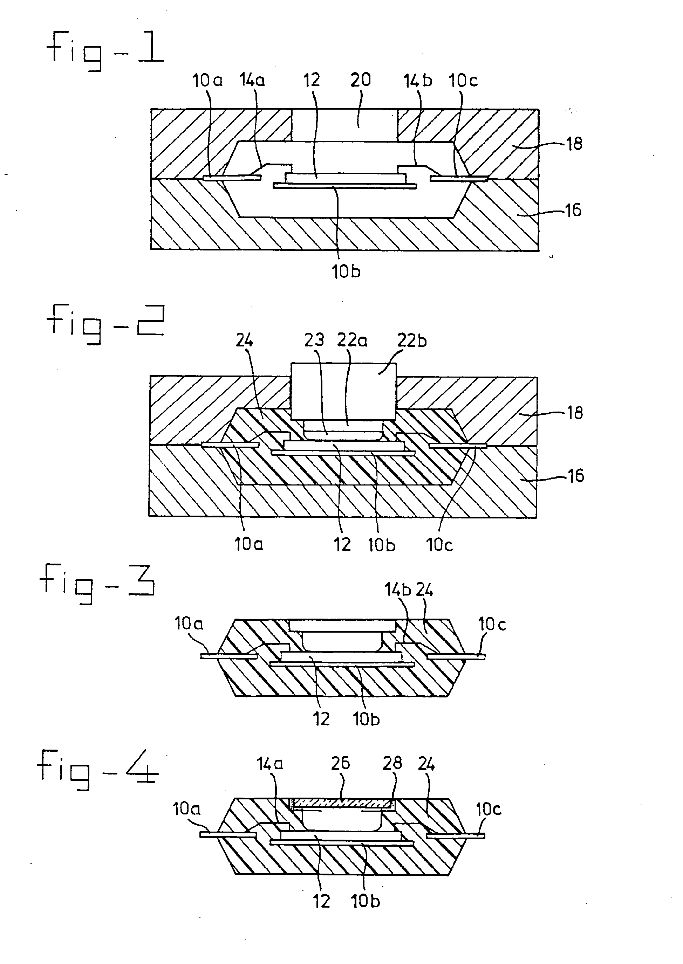

During the manufacturing of integrated semi-conductor circuits in general a large number of these circuits are made simultaneously onto one single large silicon platelet, a so-called wafer. After completing the actual integration process the wafer is divided into the separated semi-conductor circuits or chips using known techniques, for instance by cutting or etching. (In English literature these chip are also called "die" or "pellet"). Thereafter, each chip is positioned on a metal framework comprising contact pins which are mutually connected through connecting parts such, that as a whole they form a so-called lead frame. The central section of such a lead frame comprises a mounting surface onto which the chip can be positioned and attached by means of soldering or another method which is known as such. After fixing the chip in this manner onto the central section of the lead frame the bonding wires are attached between the various contact pins and the connecting surfaces or "pellets" on the chip. The result at the end of this operation is schematically shown in cross-section in figure 1.

In figure 1 the contact pins are indicated by 10a and 10c, whereas the central mounting surface of the lead frame is indicated by 10b. Onto this mounting surface 10b (in the English language called a die pad) the chip 12 is fixed in a known manner, which does not play a role within the scope of the invention. Furthermore, between the connecting pins 10a and 10c on the one hand and the chip 12 on the other hand bonding wires 14a and 14b are attached. All the used techniques therefore are known as such and do not require further explanation.

In the illustrated embodiment the mould comprises two parts, i.e. a bottom part 16 and a cover part 18. In contrast with the usually completely closed moulds an opening 20 is made in the cover part 18 above the semi-conductor circuit 12.

A further intermediate step in the method is illustrated in figure 2. The opening 20 is closed by means of inwards extending part 22 of which the cross-sectional shape corresponds with the shape of the opening 20. In the illustrated embodiment this part comprises of a central column 22a and a ring 22b, fitting about said column. The column 22a extends further inside than the ring 22b for reasons which will be made clear hereinafter.

Preceding the insertion of the part 22 the under side thereof, especially the under surface of column 22a, is applied with a certain amount of heat resistant deformable material 23 which consists of a gel in the form of a ring or a continuous layer, said material being of a type which not or hardly adheres to the plastic which hereafter will form the housing. The amount of this material is selected such that after locating the part 22 a section of the semi-conductor circuit surface is covered or enclosed by this material as is illustrated in figure 2. Of course, as an alternative the deformable material can be applied to the surface of the semi-conductor circuit whereafter the part 22 is brought in position. However, the first method is preferred because of the very simple correct positioning of the material.

Preferably the deformable material consists of a silicon gel. This material does not or hardly adhere to the various types of epoxy which in general are used for making the actual encapsulation.

Thereafter the epoxy or resin is injected in the free space in the mould to create the encapsulation. The resin is indicated by 24 in figure 2.

After at least partly hardening of the now encapsulated semi-conductor circuit, removing it out of the mould and removing the deformable material 23 the intermediate product will be obtained which is shown in cross-section in figure 3. The semi-conductor circuit is partly encapsulated and a part of the upper surface of the semi-conductor circuit is still left free. The opening above this section has a stepwise shape as is clearly visible in figure 3. This shape, resulting from the use of a column 22a and a separate tube 22b is suitable for mounting a window 26 in the way as illustrated in figure 4. This window can be attached for instance by using a suitable adhesive 28.

It will be clear that the presented method can be applied to make more cavities above one semi-conductor circuit. In that case the mould should comprise a corresponding number of openings, each of which has to be closed by an inwards extending element, such as the combination of a column 22a and the tube 22b.

Furthermore, it will be clear that instead of this combination one single component of adapted shape can be applied.

Also it will be clear that the position of the open cavity can be varied based on the location of the active area on the 'die'. In that case the mould should comprise a corresponding opening 20 the position of which has to be closed by an inwards extending element.

## Claims

1. A method of encapsulating a semiconductor chip with a plastic housing comprising the steps of:
a) attaching the semiconductor chip (12) on a mounting surface (10b) of a leadframe (10a, 10b, 10c) such that an upper surface of the semiconductor chip is exposed;
b) attaching bonding wires (14a, 14b) between contact surfaces of the semiconductor chip and selected parts of the leadframe;
c) placing the structure obtained in step b) in a mould (16,18) which comprises an inwards extending section (22a, 22b) with an end surface extending parallel to the upper surface and being at a short distance of the upper surface and a layer of deformable heat resistant material (23) is applied to the end surface such that a part of the upper surface is covered by the layer of deformable heat resistant material, the deformable heat resistant material is of a material which does not adhere or hardly adheres to the plastic housing to be formed; and
d) forming the plastic housing by injecting a resin into the mould with the structure obtained in stap b) therein after step c) such that a part of the leadframe, the bonding wires and the semiconductor chip are encapsulated, whereby the part of the upper surface is maintained free from the resin by the layer of deformable heat resistant material;
**characterised in that**
the deformable heat resistant material consists of a gel.

2. A method of encapsulating a semiconductor chip with a plastic housing according to claim 1, wherein the gel is a silicon gel.

## Patentansprüche

1. Verfahren zum Einkapseln eines Halbleiterchips mit einem Kunststoffgehäuse umfassend die Schritte:
a) Befestigen des Halbleiterchips (12) auf einer Montageoberfläche (10b) eines Leiterrahmens (10a, 10b, 10c) so, dass eine Oberseite des Halbleiterchips freiliegt;
b) Befestigen von Bonddrähten (14a, 14b) zwischen Kontaktflächen des Halbleiterchips und ausgewählten Teilen des Leiterrahmens;
c) Einlegen der im Schritt b) erhaltenen Struktur in eine Form (16, 18), welche einen sich nach innen erstreckenden Abschnitt (22a, 22b) mit einer sich parallel zu der Oberseite erstreckenden und in einem geringem Abstand von der Oberseite befindlichen Endfläche aufweist und eine Schicht eines verformbaren wärmebeständigen Materials (23) auf der Endfläche aufgebracht ist, so dass ein Teil der Oberseite durch das verformbare wärmebeständige Material abgedeckt wird, wobei das verformbare wärmebeständige Material aus einem Material besteht, welches nicht oder kaum an dem auszubildenden Kunststoffgehäuse anhaftet; und
d) Erzeugen des Kunststoffgehäuses durch Einspritzen eines Harzes in die Form mit der im Schritt b) erhaltenen Struktur dahinein nach dem Schritt c) so, dass ein Teil des Leiterrahmens, der Bonddrähte und des Halbleiterchips eingekapselt wird, wobei der Teil der Oberseite durch die Schicht des verformbaren wärmebeständigen Materials von dem Harz freigehalten wird;
**dadurch gekennzeichnet, dass**
das wärmebeständige Material aus einem Gel besteht.

2. Verfahren zum Einkapseln eines Halbleiterchips mit einem Kunststoffgehäuse nach Anspruch 1, wobei das Gel ein Silizium-Gel ist.

## Revendications

1. procédé d'encapsulation d'une puce à semi-conducteur avec un boîtier en plastique comprenant les étapes consistant à :
a) fixer la puce à semi-conducteur (12) sur une surface de montage (10b) d'une grille de connexion (10a, 10b, 10c) de telle sorte qu'une surface supérieure de la puce à semi-conducteur se trouve à nu ;
b) fixer des fils de liaison (14a, 14b) entre les surfaces de contact de la puce à semi-conducteur et les parties sélectionnées de la grille de connexion ;
c) placer la structure obtenue à l'étape b) dans un moule (16, 18) qui comprend une section s'étendant vers l'intérieur (29a, 29b) avec une surface d'extrémité s'étendant parallèlement à la surface supérieure et étant à une courte distance de la surface supérieure, et une couche de matériau thermorésistant déformable (23) est appliquée sur la surface d'extrémité, de telle sorte qu'une partie de la surface supérieure est recouverte de la couche de matériau thermorésistant déformable, le matériau thermorésistant déformable est un matériau qui n'adhère pas ou qui adhère très peu au boîtier en plastique à former ; et
d) former le boîtier en plastique en injectant une résine dans le moule avec la structure obtenue à l'étape b) après l'étape c), de telle sorte qu'une partie de la grille de connexion, des fils de liaison et de la puce à semi-conducteur se trouvent encapsulés, moyennant quoi la partie de la surface supérieure est maintenue protégée de la résine par la couche du matériau thermorésistant déformable ;
**caractérisé en ce que**
le matériau thermorésistant déformable consiste en un gel.

2. Procédé d'encapsulation d'une puce à semi-conducteur avec un boîtier en plastique selon la revendication 1, dans lequel le gel est un gel de silicone.
